# FASCICULE DE BREVET EUROPEEN

(11) **EP 1 550 000 B1**
(45) Date de publication et mention de la délivrance du brevet: **11.06.2014**
(21) Numéro de dépôt: 03807862.2
(22) Date de dépôt: 01.10.2003
(51) Int. Cl.: G02F 1/153, B32B 17/10

(54) **PROCEDE DE SUPPRESSION DES DEFAUTS PONCTUELS INCLUS AU SEIN D'UN DISPOSITIF ELECTROCHIMIQUE**
VERFAHREN ZUR BESEITIGUNG VON PUNKTUELLEN DEFEKTEN BEI EINER ELEKTROCHEMISCHEN EINRICHTUNG
METHOD FOR ELIMINATING PUNCTUAL DEFECTS COMPRISED IN AN ELECTROCHEMICAL DEVICE

(30) Priorité: 09.10.2002 FR 0212520
(43) Date de publication de la demande: 06.07.2005
(73) Titulaire: Sage Electrochromics, Inc., Faribault, MN 55021 (US)
(72) Inventeur: BETEILLE, Fabien, F-31250 Revel (FR)
(74) Mandataire: Jamet, Vincent
(86) Numéro de dépôt international: PCT/FR2003/002871
(87) Numéro de publication internationale: WO 2004/034138

(56) Documents cités:
- FR-A- 2 781 084

## Description

La présente invention a pour objet un procédé de suppression des défauts ponctuels susceptibles d'être présents au sein d'un dispositif électrochimique, notamment un système électrocommandable du type vitrage et à propriétés optiques et/ou énergétiques variables, d'un dispositif photovoltaïque ou au sein d'un dispositif électroluminescent.

Elle vise plus précisément un procédé de suppression des défauts qui sont susceptibles de subvenir à un stade avancé de la fabrication du dispositif, notamment à un stade où la valeur marchande du dispositif est élevée.

Malgré le soin apporté à la fabrication de ces dispositifs (travail en salle blanche, alimentation pulsée des cathodes pour le dépôt des couches, ligne verticale de dépôt, substrats de bonne qualité), il peut arriver que des défauts de surface communément appelés « pinholes » apparaissent. Ces « pinholes » ont de multiples origines. Il peut s'agir de poussières environnementales qui n'ont pas été retenues et/ou éliminées par les organes de filtration de l'atmosphère des enceintes de traitement ou encore de résidus provenant des dispositifs devant assurer le dépôt des diverses couches conformant les systèmes actifs (électrochromes, photovoltaïques, électroluminescents...), notamment au niveau des cibles, ou bien encore une mauvaise qualité du substrat. Ces défauts sont rédhibitoires car ils peuvent engendrer par mise en contact des électrodes une détérioration permanente de la fonctionnalité de ces vitrages.

Compte tenu de la perte financière que peut engendrer la mise au rebut d'un dispositif incorporant un nombre réduit de défauts, on a cherché à pouvoir supprimer ces défauts, surtout à un stade avancé du processus de fabrication.

Une première technique visant à supprimer les défauts de surface consiste, après avoir détecter visuellement le défaut qui se présente sous la forme d'une auréole, à procéder à l'ablation du matériau constituant la couche au niveau de l'auréole, à l'aide d'un dispositif de grattage du type cutter ou équivalent.

Cette première technique permet de supprimer efficacement les défauts mais l'ablation de ceux-ci ne peut être effectuée que lorsque les couches du système actif sont encore accessibles, c'est-à-dire pour un pare-brise feuilleté avant l'étape de pose de l'intercalaire de feuillage et l'assemblage des substrats, ce qui réduit d'autant le domaine d'application de cette technique (elle est inopérante lorsque le substrat et le système actif sont complètement assemblés, les couches du système actif étant inaccessibles).

On connaît une deuxième technique d'ablation des couches d'un système actif qui utilise un rayonnement laser. Cette deuxième technique est classique dans le domaine du margeage des couches et permet grâce au rayonnement laser de supprimer en périphérie d'un substrat verrier par exemples des couches à l'argent pour éviter des phénomènes de corrosion de l'ensemble du système actif, ou pour limiter des phénomènes de courant de fuite pour un système actif de type électrochrome ou photovoltaïque.

Cette deuxième technique est très efficace pour supprimer en partie ou en totalité des couches formant un système actif (le matériau des couches étant totalement ou partiellement détruit par le laser).

De plus, la technique de margeage est un procédé limité à l'ablation des couches seulement situées en périphérie du substrat, c'est-à-dire dans un lieu où l'évacuation du matériau détruit est facilitée. On comprend aisément qu'il n'est pas possible d'opérer au travers d'un substrat feuilleté, il en effet nécessaire que le matériau détruit par le rayonnement laser ne reste pas emprisonné entre les deux substrats formant le feuilleté.

Les inventeurs ont de manière tout à fait inattendue découvert que moyennant une adaptation des conditions d'utilisation du rayonnement laser, il est possible d'utiliser ce type de rayonnement pour détruire des couches d'un système actif, même lorsque celles-ci ne sont pas situées en périphérie d'un substrat feuilleté.

Le procédé objet de l'invention est particulièrement destiné pour des vitrages dits « intelligents » qui sont aptes à s'adapter aux besoins des utilisateurs.

En ce qui concerne les vitrages « intelligents », il peut s'agir du contrôle de l'apport solaire à travers des vitrages montés en extérieur dans des bâtiments ou des véhicules du type automobile, train ou avion. Le but est de pouvoir limiter un échauffement excessif à l'intérieur des habitacles/locaux, mais uniquement en cas de fort ensoleillement.

Il peut aussi s'agir du contrôle du degré de vision à travers des vitrages, notamment afin de les obscurcir, de les rendre diffusant voire d'empêcher toute vision quand cela est souhaitable. Cela peut concerner les vitrages montés en cloisons intérieures dans les locaux, les trains, les avions ou montés en vitres latérales d'automobile. Cela concerne aussi les miroirs utilisés comme rétroviseurs, pour éviter ponctuellement au conducteur d'être ébloui, ou les panneaux de signalisation, pour que des messages apparaissent quand cela est nécessaire, ou par intermittence pour mieux attirer l'attention. Des vitrages que l'on peut rendre à volonté diffusants peuvent être utilisés quand on le souhaite comme écrans de projection.

Il existe différents systèmes électrocommandables permettant ce genre de modifications d'aspect/de propriétés thermiques.

Pour moduler la transmission lumineuse ou l'absorption lumineuse des vitrages, il y a les systèmes dits viologènes, comme ceux décrits dans les brevets US-5 239 406 et EP-612 826.

Pour moduler la transmission lumineuse et/ou la transmission thermique des vitrages, il y a aussi les systèmes dits électrochromes. Ceux-ci, de manière connue, comportent généralement deux couches de matériau électrochrome séparées par une couche d'électrolyte et encadrées par deux couches électroconductrices. Chacune des couches de matériau électrochrome peut insérer réversiblement des cations et des électrons, la modification de leur degré d'oxydation suite à ces insertions/désinsertions conduisant à une modification dans ses propriétés optiques et/ou thermiques.

Il existe aussi des systèmes appelés « valves optiques ». il s'agit de films comprenant une matrice de polymère généralement réticulé dans laquelle sont dispersées des micro-gouttelettes contenant des particules qui sont capables de se placer selon une direction privilégiée sous l'action d'un champ magnétique ou électrique. Il est ainsi connu du brevet WO93/09460 une valve optique comprenant une matrice en polyorganosilane et des particules du type polyiodure qui interceptent beaucoup moins la lumière quand le film est mis sous tension.

On peut aussi citer les systèmes dits électroluminescents, qui de manière connue, comportent généralement au moins une couche mince d'un matériau électroluminescent organique ou inorganique prise en sandwich entre deux électrodes appropriées.

Il est d'usage de ranger les systèmes électroluminescents en plusieurs catégories suivant qu'ils sont de type organique, communément appelé système OLEDs pour « Organic Light Emitting Diode », ou PLEDs pour « polymer Light Emitting Diode » ou de type inorganique et dans ce cas communément appelé système TFEL pour « Thin Film Electroluminescent ».

L'invention peut également trouver son application pour des systèmes « intelligents » appartenant à la famille des systèmes photovoltaïques (qui convertissent de l'énergie lumineuse en en énergie électrique). Un exemple d'un empilement de couches fonctionnelles photovoltaïques est du type par exemple Mo/CIS:Ga/CdS/ZnO, ou du type Al/a-Si/ZnO :Al.

L'invention a donc pour but de proposer un procédé de suppression, à l'aide d'un faisceau d'un rayonnement laser, des défauts d'aspects situés au sein d'un dispositif feuilleté formé d'au moins un premier substrat et d'au moins un second substrat, ledit feuilleté incorporant entre lesdits premier et second substrats au moins un système actif « intelligent » tel que précédemment défini. Il est fait référence au document FR 2 781 084. L'invention a tout d'abord pour objet un procédé tel que défini dans la revendication 1.

Grâce à ces dispositions, il est possible de réparer des dispositifs incorporant des systèmes actifs, soit à un stade avancé de leur fabrication afin de leur redonner leur valeur marchande initiale, soit bien après leur fabrication au cours d'une réparation par exemple à la suite d'une opération de maintenance.

Dans des modes de réalisation préférés de l'invention, on peut éventuellement avoir recours en outre à l'une et/ou à l'autre des dispositions suivantes :
- la phase de repérage du défaut est réalisée par voie optique soit de manière manuelle (intervention humaine), soit de manière automatique à l'aide d'un logiciel de traitement d'image,
- la phase de pointage est réalisée en utilisant une puissance réduite du faisceau laser,
- l'ablation du défaut consiste en un déplacement du faisceau laser en suivant sensiblement la périphérie du défaut,
- la longueur d'onde du faisceau laser est adaptée de manière à ce que le faisceau soit d'une part, absorbé par les couches formant le système actif et d'autre part, transmis au travers du substrat,
- l'ablation du défaut est réalisée au travers du premier substrat,
- l'ablation du défaut est réalisée au travers du second substrat.

D'autres caractéristiques et avantages de l'invention apparaîtront au cours de la description suivante de plusieurs de ses formes de réalisation, données à titre d'exemple non limitatif.
- la figure 1 illustre un défaut susceptible d'être supprimé par le procédé objet de l'invention

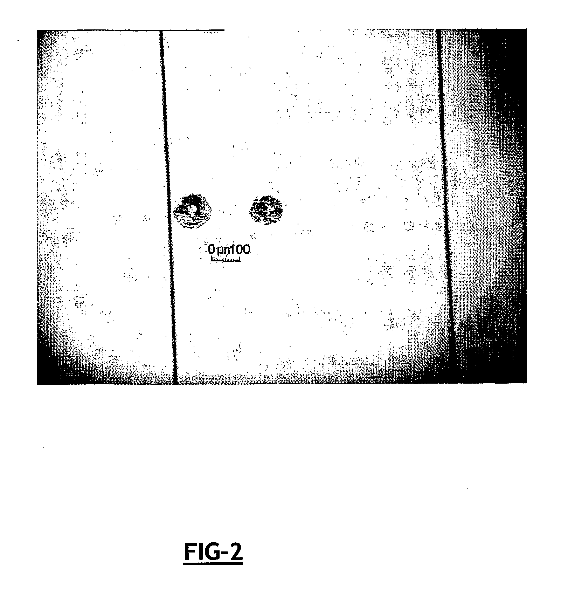

- la figure 2 est similaire à la figure 1 mais après suppression du défaut

L'invention s'applique à des vitrages au sens large : les substrats porteurs sont généralement rigides et transparents, du type verre ou polymère comme du polycarbonate ou du polymétacrylate de méthyle (PMMA). L'invention inclut cependant les substrats qui sont flexibles ou semi-flexibles, à base de polymère.

Ces substrats sont juxtaposés de manière à conformer un dispositif feuilleté à l'aide d'une ou plusieurs feuilles en polymère thermoplastique du type EVA (éthylènevinylacétate), PVB (polyvinylbutyral), PU (polyuréthanne), l'intercalaire de feuilletage réunissant au moins un premier substrat à au moins un second substrat.

On peut aussi éviter une opération de feuilletage qui se fait à chaud, éventuellement sous pression, en substituant la feuille intercalaire thermoplastique conventionnelle par une feuille adhésive double face, auto-supportée ou non, qui est disponible commercialement et qui a l'avantage d'être très fine.

Entre ces premier et second substrats, on intercale au moins un système actif « intelligent » tel que précédemment défini ainsi que des couches électroconductrices qui conforment des anodes, des cathodes, et plus généralement des électrodes, ces couches électroconductrices étant adaptées pour être reliées par l'intermédiaire d'amenées de courant, à une source de courant et/ou de tension électrique de manière à activer/désactiver le système actif.

Par souci de concision, on désigne par le terme « empilement actif » ou « empilement électroactif » la ou les couches actives du système, c'est-à-dire l'ensemble des couches du système exceptées les couches appartenant aux électrodes. Par exemple, pour un système électrochrome, il est donc essentiellement constitué d'une couche d'un matériau électrochrome anodique, d'une couche d'électrolyte et d'une couche d'un matériau électrochrome cathodique, chacune de ces couches pouvant être constituée d'une mono-couche où d'une pluralité de couches superposées concourant à la même fonction.

Généralement chaque électrode contient une couche électroconductrice ou plusieurs couches électroconductrices superposées, que l'on considérera par la suite comme une couche unique. Pour une alimentation électrique correcte de la couche électroconductrice, on a généralement besoin de deux amenées de courant, disposées le long de deux bords opposés de la couche quand elle a les contours d'un rectangle, d'un carré ou d'une forme géométrique similaire du type parallélogramme.

Un exemple de couche électroconductrice est une couche à base d'oxyde métallique dopé, notamment de l'oxyde d'indium dopé à l'étain appelé ITO ou de l'oxyde d'étain dopé au fluor SnO₂:F, éventuellement déposée sur une précouche du type oxyde, oxycarbure ou oxynitrure de silicium. On peut en outre inclure une couche à fonction optique et/ou à fonction de barrière aux alcalins quand le substrat est en verre.

A titre d'exemple, les amenées de courant des électrodes peuvent être sous forme d'un fil conducteur (ou de plusieurs fils conducteurs assemblés). Ces fils peuvent être en cuivre, en tungstène ou en tungstène graphité. Ils peuvent avoir un diamètre allant de 10 à 600 µm. Ce type de fils suffit en effet à alimenter électriquement de façon satisfaisante les électrodes, et sont remarquablement discrets : il peut devenir inutile de les masquer lors du montage du dispositif.

La configuration des amenées de courant est très adaptable. On a décrit des systèmes actifs sensiblement rectangulaires, mais ils peuvent avoir quantités de formes géométriques différentes, en suivant notamment la forme géométrique de leur substrat porteur : cercle, carré, demi-cercle, ovale, tout polygone, losange, trapèze, carré, tout parallélogramme... Et dans ces différents cas de figure, les amenées de courant ne sont plus nécessairement pour chaque électrode à alimenter des «paires » d'amenée de courant se faisant face. Il peut ainsi s'agir, par exemple, d'amenées de courant qui font tout le tour de la couche conductrice (ou tout au moins qui longe une bonne partie de son pourtour), ceci étant réalisable lorsque l'amenée de courant est un simple fil conducteur. Il peut même s'agir d'amenées de courant ponctuelles, notamment quand le dispositif est de petite taille.

Le dispositif selon l'invention peut utiliser un ou plusieurs substrats en verre teinté(s) dans la masse. Avantageusement, s'il s'agit d'un vitrage feuilleté, le verre teinté dans la masse est le verre destiné à être tourné vers l'intérieur du local ou de l'habitacle, le verre extérieur étant clair. Le verre teinté permet de régler le niveau de transmission lumineuse du vitrage. Placé du côté intérieur, on limite son échauffement par absorption. Le ou les verre(s) peut (peuvent) aussi être bombé(s), c'est le cas dans les applications en tant que toit automobile électrochrome notamment.

Le vitrage selon l'invention peut comporter des fonctionnalités supplémentaires : il peut par exemple comporter un revêtement réfléchissant les infra-rouges, comme cela est décrit dans le brevet EP-825 478. Il peut aussi comporter un revêtement hydrophile, anti-reflets, hydrophobe, un revêtement photocatalytique à propriétés anti-salissures comprenant de l'oxyde de titane sous forme anatase, comme cela est décrit dans le brevet WO 00/03290.

Un tel substrat feuilleté est susceptible, malgré le grand soin apporté à sa fabrication, de comporter quelques défauts (« pinholes ») que le procédé objet de l'invention se propose de supprimer.

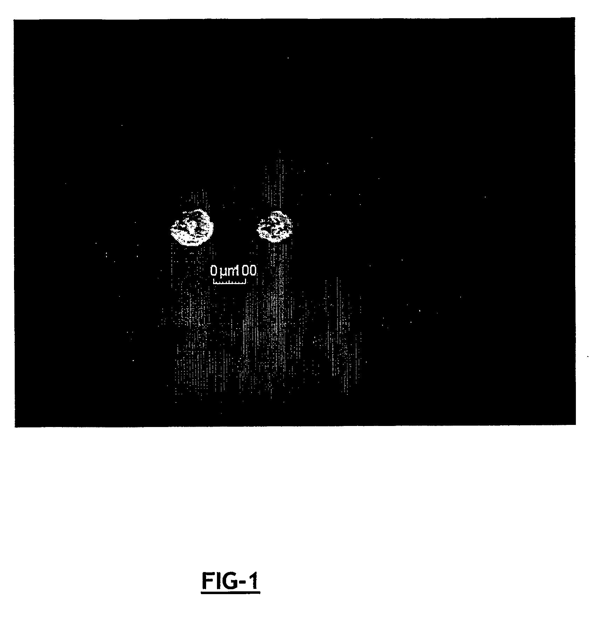

Ces défauts d'aspects sont illustrés à la figure 1, et se présentent sous la forme d'une auréole visuelle de décoloration dont les dimensions caractéristiques peuvent être comprises dans la fourchette de 0.2 mm à 10 cm environ. Cette auréole visuelle de décoloration est caractéristique des défauts des systèmes actifs « intelligents » de type électrochrome. Cette zone décolorée ne représente pas la taille réelle du défaut proprement dit, elle n'est que la conséquence physique de la présence du défaut. Ce défaut visuel se concrétise par la présence d'un courant de fuite qui peut être mesuré.
Pratiquement, le défaut ou le « pinhole » a une taille réelle de l'ordre de 20 à 50 µm, mais sa présence dans le système actif crée des phénomènes de puits de potentiels autour de ce dernier, dont les effets se traduisent par une décoloration sensiblement centrée autour de ce dernier, sur une zone beaucoup plus vaste qui peut atteindre les 2 à 100 mm précédemment mentionnés.

Après avoir repéré ce défaut d'une manière « manuelle », à l'aide de l'oeil de l'utilisateur, éventuellement complété par un appareil de grossissement optique (caméra, appareil optique), ou d'une manière automatique, à l'aide d'une association entre un appareil optique et un logiciel de traitement optique, le substrat feuilleté est positionné en regard d'un laser.

En fait la longueur d'onde du faisceau laser est adaptée de manière à pouvoir d'une part traverser sans être absorbé le substrat et d'autre part être absorbé par les matériaux formant les couches de l'empilement du système actif.

Pour l'exemple représenté en figure 1, le système actif est de type électrochrome et la longueur d'onde choisie est de 1.06 µm environ et le laser utilisé est de type YAG pulsé.

On pourra aussi utiliser un laser de type continu. Quel que soit le type de laser utilisé (à impulsion, continu), on circonscrit le défaut à l'aide faisceau.

On procède alors au pointage du défaut à l'aide d'un train d'impulsions à puissance réduite du laser et on relève le décalage entre la cible et le défaut. Lors de l'ablation du défaut, on intègrera la mesure de ce décalage.

L'ablation proprement dite consiste à décrire sensiblement un cercle autour du défaut de manière à isoler électriquement la zone effective du défaut et à minimiser ainsi l'impact visuel de cette ablation. La destruction des couches formant l'empilement du système actif a lieu en pointant le faisceau laser sur le défaut (en prenant soin la valeur du décalage), en décrivant un cercle autour de ce dernier tout en pulsant le faisceau.

A titre d'exemple, pour ablater le défaut représenté en figure 1, les paramètres du faisceau laser sont les suivants (30% de la puissance maximale, 50 kHz, cercle de 0.5 mm de rayon, largeur du faisceau 80 µm, vitesse de déplacement du faisceau 5 m/s).

On pourra quantifier la qualité de l'ablation laser par la mesure du courant de fuite qui est consécutif à la présence du défaut. En effet, il existe une relation de proportionnalité entre la surface du défaut (pour un système actif, il s'agit d'une auréole non colorée) et la valeur de l'intensité du courant de fuite. Ainsi, à l'aide du procédé objet de l'invention, l'intensité du courant de fuite sera divisée par un facteur de l'ordre de 10 au coeur du margeage entourant le vitrage.

En fonction du type de l'empilement formant le système actif, on adaptera les conditions de fonctionnement du laser.

Par ailleurs, il est possible de procéder à l'ablation des défauts du substrat verrier indifféremment à partir de la face 1 (dirigée vers l'extérieur) ou de la face 4 (dirigée vers l'intérieur). Néanmoins, il peut être plus pratique dans une configuration asymétrique (couches anti-solaires, verres teintés, etc) de choisir le côté de l'ablation qui engendre le moins de défauts visuels et la meilleure ablation des couches « actives ».

## Revendications

1. Procédé de suppression, à l'aide d'un faisceau d'un rayonnement laser, des défauts situés au sein d'un dispositif feuilleté formé d'au moins un premier substrat et d'au moins un second substrat, ledit feuilleté incorporant entre lesdits premier et second substrat au moins un système actif électrocommandable, consistant en :
- une phase de repérage d'au moins un défaut situé au sein du système actif,
- une phase d'ablation du défaut consistant à circonscrire ce dernier à l'aide dudit faisceau laser, l'ablation du défaut consistant en un isolement électrique de la zone périphérique du défaut par rapport au système actif incluant le défaut, le défaut étant circonscrit à l'aide d'une pluralité d'impulsions laser,
**caractérisé en ce qu'**on procède à une phase de pointage du défaut à l'aide d'au moins une première impulsion de faisceau du laser, la phase de pointage incorporant une phase intermédiaire de recalage du faisceau laser en fonction de l'écart relevé entre l'une desdites premières impulsions et le défaut.

2. Procédé selon la revendication 1, dans lequel la phase de repérage du défaut est réalisée par voie optique soit de manière manuelle, intervention humaine, soit de manière automatique à l'aide d'un logiciel de traitement d'image. /

3. Procédé selon la revendication 1 ou 2, dans lequel la phase de pointage est réalisée en utilisant une puissance réduite du faisceau laser.

4. Procédé selon l'une quelconque des revendications précédentes, dans lequel l'ablation du défaut consiste en un déplacement du faisceau laser en suivant sensiblement la périphérie du défaut.

5. Procédé selon l'une quelconque des revendications précédentes, dans lequel la longueur d'onde du faisceau laser est adaptée de manière à ce que le faisceau soit d'une part, absorbé par les couches formant le système actif et d'autre part, transmis au travers du substrat.

6. Procédé selon l'une quelconque des revendications précédentes, dans lequel l'ablation du défaut est réalisée au travers du premier substrat.

7. Procédé selon l'une quelconque des revendications 1 à 5, dans lequel l'ablation du défaut est réalisée au travers du second substrat.

## Patentansprüche

1. Verfahren zur Beseitigung der Defekte innerhalb einer Mehrlagenvorrichtung, die von wenigstens einem ersten Substrat und von wenigstens einem zweiten Substrat gebildet ist, mit Hilfe eines Laserstrahlenbündels, wobei der Mehrlagenaufbau zwischen dem ersten und dem zweiten Substrat wenigstens ein elektrisch steuerbares aktives System einschließt, bestehend in:
- einer Phase zum Orten wenigstens eines innerhalb des aktiven Systems befindlichen Defekts,
- einer Phase zum Abtragen des Defekts, die darin besteht, letzteren mit Hilfe des Laserstrahls zu umgrenzen, wobei das Abtragen des Defekts in einem elektrischen Isolieren des Umfangsbereichs des Defekts gegenüber dem den Defekt einschließenden aktiven System besteht, wobei der Defekt mit Hilfe einer Vielzahl von Laserimpulsen umgrenzt wird,
**dadurch gekennzeichnet, dass** eine Phase zum Anpeilen des Defekts mit Hilfe wenigstens eines ersten Laserstrahlimpulses durchgeführt wird, wobei die Anpeilungsphase eine Zwischenphase zur Neueinstellung des Laserstrahls in Abhängigkeit von der zwischen einem der ersten Impulse und dem Defekt festgestellten Abweichung einschließt.

2. Verfahren nach Anspruch 1, wobei die Phase der Ortung des Defekts auf optischem Weg entweder manuell, menschliches Eingreifen, oder automatisch mit Hilfe einer Bildverarbeitungssoftware durchgeführt wird.

3. Verfahren nach Anspruch 1 oder 2, wobei die Anpeilungsphase unter Verwendung einer verminderten Leistung des Laserstrahls durchgeführt wird.

4. Verfahren nach einem der vorstehenden Ansprüche, wobei das Abtragen des Defekts in einem Bewegen des Laserstrahls unter Folgen im Wesentlichen des Umfangs des Defekts besteht.

5. Verfahren nach einem der vorstehenden Ansprüche, wobei die Wellenlänge des Laserstrahls derart eingestellt ist, dass der Strahl einerseits durch die das aktive System bildenden Lagen aufgenommen wird und andererseits durch das Substrat hindurch geleitet wird.

6. Verfahren nach einem der vorstehenden Ansprüche, wobei das Abtragen des Defekts durch das erste Substrat hindurch vollzogen wird.

7. Verfahren nach einem der Ansprüche 1 bis 5, wobei das Abtragen des Defekts durch das zweite Substrat hindurch vollzogen wird.

## Claims

1. Method of eliminating, using a beam of laser radiation, defects lying within a laminate formed from at least a first substrate and from at least a second substrate, said laminate incorporating, between said first and second substrates, at least one electrically controllable active system consisting of:
- a phase of locating at least one defect lying within the active system; and
- a phase of ablating the defect, consisting in circumscribing the latter using said laser beam, ablation of the defect consisting in electrically isolating the peripheral region of the defect relative to the active system that includes the defect, the defect being circumscribed using a number of laser pulses,
**characterized in that** a phase of pinpointing the defect is carried out using at least a first laser beam pulse, the pinpointing phase incorporating an intermediate phase of resetting the laser beam according to the deviation noted between one of said first pulses and the defect.

2. Method according to Claim 1, wherein the phase of locating the defect is carried out by optical means, either manually, human intervention or automatically using image processing software.

3. Method according to Claim 1 or 2, wherein the pinpointing phase is carried out using a low power level of the laser beam.

4. Method according to any one of the preceding claims, wherein ablation of the defect consists in moving the laser beam so as to follow approximately the periphery of the defect.

5. Method according to any one of the preceding claims, wherein the wavelength of the laser beam is adapted so that the beam is, on the one hand, absorbed by the layers forming the active system and, on the other hand, transmitted through the substrate.

6. Method according to any one of the preceding claims, wherein ablation of the defect is carried out through the first substrate.

7. Method according to any one of Claims 1 to 5, wherein ablation of the defect is carried out through the second substrate.
